Europäisches Patentamt

(19) European Patent Office

Office européen des brevets

(11) EP 0 825 417 A2

## (12) EUROPEAN PATENT APPLICATION

(43) Date of publication:
25.02.1998 Bulletin 1998/09

(51) Int. Cl.⁶: $G01C\ 19/56$

(21) Application number: 97113705.4

(22) Date of filing: 07.08.1997

(84) Designated Contracting States:
AT BE CH DE DK ES FI FR GB GR IE IT LI LU MC NL PT SE

(30) Priority: 12.08.1996 JP 212614/96

(71) Applicant:
TOYOTA JIDOSHA KABUSHIKi KAISHA
Aichi (JP)

(72) Inventor: **Sugitani, Nobuyoshi**
**Toyota-shi, Aichi (JP)**

(74) Representative:
**Leson, Thomas Johannes Alois, Dipl.-Ing. et al**
**Patentanwälte**
**Tiedtke-Bühling-Kinne & Partner,**
**Bavariaring 4**
**80336 München (DE)**

### (54) Angular velocity detecting apparatus

(57) The angular velocity detecting apparatus comprises a vibrator 102 having first and second piezoelectric crystal portions 4p, 6p made of a piezoelectric crystal and a circuit 103. This circuit 103 gives an electrode 4m a potential $V_A$ varying at a predetermined period, and fixes the potential of an electrode 4u at a predetermined value, and detects an alternating voltage signal $V_K$ having a signal component corresponding to a potential difference occurring between the other electrodes 6a, 6b.

**Fig.1**

EP 0 825 417 A2

## Description

### BACKGROUND OF THE INVENTION

#### Field of the Invention

The present invention relates to an angular velocity detecting apparatus for detecting an angular velocity of a detected body under motion by detecting Coriolis' force and, more particularly, to the technology for detecting the angular velocity at high accuracy. The angular velocity detecting apparatus of the present invention can be applied to navigation systems or posture control of moving bodies such as cars, airplanes, or ships, correction for vibration of image pickup device, and so on.

#### Related Background Art

A so-called piezoelectric vibration gyro provided with a piezoelectric vibrator is a kind of the angular velocity detecting apparatus. When a voltage is applied to such a piezoelectric vibrator, the piezoelectric vibrator is deformed by the inverse piezoelectric effect, and the piezoelectric vibrator vibrates where the applied voltage satisfies a predetermined oscillation condition.

When the piezoelectric vibrator is fixed to a detected body and when the detected body is rotated as vibrating this piezoelectric vibrator, the Coriolis' force based on the vibrating velocity of the piezoelectric vibrator and the angular velocity of rotation of the detected body acts on the piezoelectric vibrator. Since the piezoelectric vibrator is distorted by the Coriolis' force, the Coriolis' force can be detected by detecting an amount of this distortion, based on the piezoelectric effect of the piezoelectric vibrator. When the vibration of the piezoelectric vibrator is constant, the Coriolis' force is proportional to the angular velocity of rotation of the moving body. Therefore, the angular velocity of rotation of the detected body can be detected from the Coriolis' force detected.

Such a piezoelectric vibration gyro is described in the bulletin of Japanese Laid-open Patent Application No. Hei 5-118857. The same bulletin discloses the vibrator comprising a quadrangular prism member, for example, made of metal, a thin-film piezoelectric material covering the four side faces of the quadrangular prism member, a pair of electrodes for drive attached to one side face of the piezoelectric material, and a pair of electrodes for detection attached to another side face thereof.

### SUMMARY OF THE INVENTION

A conceivable method for vibrating the vibrator described above is one for, while changing the potential of one of the electrodes for drive from a predetermined value to another value, supplying this potential to an inverter to invert it, and applying the inverted potential to the other electrode, thereby oscillating the vibrator.

However, when the vibrator is oscillated by changing the potentials of the both electrodes in the configuration of the oscillation circuit using the inverter as described above, changes in the potentials of the two electrodes tend to cause variations in the amplitude of vibration of the vibrator. Since the variations in the amplitude of vibration of vibrator in turn change the vibrating velocity, this change will cause a change in the Coriolis' force acting on the vibrator depending upon the vibrating velocity of the vibrator and the angular velocity of the detected body, even if the angular velocity is constant. Since the angular velocity detecting apparatus detects the magnitude of the Coriolis' force by detecting an amount of strain of the vibrator due to the Coriolis' force, the detection accuracy of angular velocity detected by the angular velocity detecting apparatus for applying the potentials between the electrodes as described above is less than sufficient.

The present invention has been accomplished in view of the above problem and an object of the present invention is to provide an angular velocity detecting apparatus that can detect the angular velocity at high accuracy.

The present invention provides the angular velocity detecting apparatus for solving the above problem. The present apparatus comprises a vibrator having a first piezoelectric crystal portion made of a piezoelectric crystal, first and second electrodes provided on the first piezoelectric crystal portion, and a vibrating bar for detection mechanically coupled with the first piezoelectric crystal portion; and a circuit having excitation means for giving the first electrode a potential varying at a predetermined period, potential fixing means for fixing a potential of the second electrode at a predetermined value, and detecting means for detecting an amount of strain generated in the vibrating bar for detection.

The present apparatus is installed on a detected body such as a moving body or an electronic information device and detects the angular velocity of the detected body. Since the excitation means gives the first electrode the potential varying at the predetermined period and the potential fixing means fixes the potential of the second electrode at the predetermined value, a potential difference varying at the predetermined period, i.e., an alternating voltage is applied between the first and second electrodes. Since the first and second electrodes are provided on the first piezoelectric crystal portion, the first piezoelectric crystal portion vibrates in predetermined directions, based on the inverse piezoelectric effect.

When the detected body moves at the predetermined angular velocity in the vibrating state of the first piezoelectric crystal portion, the Coriolis' force depending upon the vibrating velocity of the first piezoelectric crystal portion and the angular velocity of the detected body acts on the first piezoelectric crystal portion, so that the first piezoelectric crystal portion starts vibrating in directions different from the predetermined directions. Since the vibrating bar for detection is mechanically coupled with the first piezoelectric crystal portion, the vibration due to the Coriolis' force on the first piezoelectric crystal portion is transmitted to the vibrating bar for detection, whereby the vibrating bar for detection undergoes vibration having a vibration component different from that in the predetermined directions.

The first piezoelectric crystal portion and the vibrating bar for detection may be made as one common portion and in this case, because the vibration due to the Coriolis' force on the first piezoelectric crystal portion is transmitted to the vibrating bar for detection, they are regarded as being mechanically coupled with each other.

Since the vibration of the vibrating bar for detection is generated by transmitting the vibration or the like based on the Coriolis' force of the first piezoelectric crystal portion to the vibrating bar for detection, the magnitude of the Coriolis' force can be detected by detecting an amount of strain due to this vibration of the vibrating bar for detection, so that the magnitude of the angular velocity of the detected body can be detected thereby. In the present apparatus, because the potential of the second electrode is fixed at the predetermined value by the potential fixing means, the vibration of the first piezoelectric crystal portion is stable and the vibration of the vibrating bar for detection, mechanically coupled with the first piezoelectric crystal portion, is also stable.

In a preferred arrangement, the potential fixing means of the present apparatus comprises an operational amplifier having an inverting input terminal, a noninverting input terminal, and an output terminal, and a resistor connected between the output terminal and the inverting input terminal of said operational amplifier and having a predetermined resistance; the second electrode is electrically connected to one of the input terminals of said operational amplifier; and a potential of the other of the input terminals of the operational amplifier is fixed at the predetermined value. The inverting input terminal and non-inverting input terminal of the operational amplifier are in an imaginal short state and the potential of the inverting input terminal is thus equal to the potential of the non-inverting input terminal. Since the second electrode is electrically connected to one of the input terminals of the operational amplifier and the potential of the other of the input terminals is fixed at the predetermined value, the potential of the second electrode is fixed at the predetermined value. Electric current flowing into one of the input terminals from the second electrode flows through this resistor to the output terminal, and this electric current is thus subjected to current-voltage conversion by a voltage drop caused by the resistor.

In a further preferred arrangement, the vibrating bar for detection has a second piezoelectric crystal portion made of a piezoelectric crystal, and a plurality of other electrodes than said first and second electrodes, the plurality of other electrodes being provided on the second piezoelectric crystal portion; the excitation means is electrically connected to the operational amplifier so that the excitation means generates the potential varying at the predetermined period from an output signal of the operational amplifier; and the detecting means is means for detecting an alternating voltage signal having a signal component corresponding to a potential difference occurring between the other electrodes, and the detecting means is electrically connected to the excitation means so that the detecting means undergoes synchronous detection of the alternating voltage signal with a signal synchronized with the output signal of the operational amplifier.

When the second piezoelectric crystal portion vibrates, a potential difference appears between the electrodes provided on the second piezoelectric crystal portion, based on the piezoelectric effect. This potential difference is converted to an alternating voltage signal having a signal component corresponding to the potential difference by waveform shaping, amplification, or phase conversion or the like. This voltage signal may be the above-stated potential difference itself. A voltage obtained by converting the electric current flowing based on this potential difference thereto is also defined as the signal component corresponding to the potential difference.

In this case, the operational amplifier outputs a signal synchronized with the vibration of the first piezoelectric crystal portion while fixing the potential of the second electrode at the predetermined value. The excitation means gives the first electrode the potential varying at the predetermined period, generated from this output signal of the operational amplifier. Accordingly, the excitation means, first piezoelectric crystal portion, and operational amplifier compose a loop, wherein while the potential of the second electrode is fixed at the predetermined value, the excitation means can give the first electrode the potential synchronized with the vibration of the first piezoelectric crystal portion and can vibrate the first piezoelectric crystal portion stably. The detecting means performs the synchronous detection of the above alternating voltage signal with the signal synchronized with the output signal of the operational amplifier.

Since the alternating voltage signal and the signal synchronized with the output signal of the operational amplifier are output from the excitation means and are generated based on the potential varying at the predetermined period, the periods of the respective signals are nearly coincident with each other. Therefore, this alternating voltage signal is synchronously detected by the signal synchronized with the output signal of the operational amplifier. Since this alternating voltage signal is generated based on the Coriolis' force acting on the first piezoelectric crystal portion, the magnitude of the DC component in the synchronously detected signal is dependent on the magnitude of the Coriolis' force. Accordingly, the angular velocity of the detected body can be detected, for example, by smoothing the synchronously detected signal using an integrating circuit. In this apparatus, utilizing the output signal from one operational amplifier, the excitation means can vibrate the first piezoelectric crystal portion and the detecting means can synchronously detect the alternating voltage signal.

The present invention will be more fully understood from the detailed description given hereinbelow and the accompanying drawings, which are given by way of illustration only and are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will be apparent to those skilled in the art from this detailed description.

BRIEF DESCRIPTION OF THE DRAWINGS

Fig. 1 is a perspective view of the angular velocity detecting apparatus according to the embodiment of the present invention.

Fig. 2 is a cross-sectional view where the vibrator shown in Fig. 1 is cut along line A-A and observed along the arrows thereof.

Fig. 3 is a cross-sectional view where the vibrator shown in Fig. 1 is cut along line B-B and observed along the arrows thereof.

Fig. 4 is a cross-sectional view where the vibrating bar shown in Fig. 1 is cut along line C-C and observed along the arrows thereof.

Fig. 5 is a block diagram to show the system of the angular velocity detecting apparatus according to the embodiment of the present invention.

Figs. 6A, 6B, 6C, 6D, 6E, 6F, 6G, 6H, 6I, 6J, 6K, 6L, 6M, 6N, 6O, 6P, 6Q, 6R are timing charts to show the waveforms of voltages at the respective nodes of the system shown in Fig. 5.

Fig. 7 is a graph to show the relationship between resistance (M$\Omega$) and phase (degree) of the current-voltage converting circuit.

Fig. 8 is a graph to show the relationship between capacitance (pF) and angle of lag (degree) of the charge amplifier.

Fig. 9 is a plan view of another vibrator.

Fig. 10 is a diagram to show cross sections of the vibrator of Fig. 9 and the processing circuit connected to this vibrator.

Fig. 11 is a plan view of another vibrator.

Fig. 12 is a diagram to show a cross section of the vibrator of Fig. 11 and the processing circuit connected to this vibrator.

Fig. 13 is a plan view of another vibrator.

Fig. 14 is a diagram to show a cross section of the vibrator of Fig. 13 and the processing circuit connected to this vibrator.

Fig. 15 is a plan view of another vibrator.

Fig. 16 is a diagram to show a cross section of the vibrator of Fig. 15 and the processing circuit connected to this vibrator.

Fig. 17 is a plan view of another vibrator.

Fig. 18 is a diagram to show a cross section of the vibrator of Fig. 17 and the processing circuit connected to this vibrator.

DETAILED DESCRIPTION OF THE PREFERRED EMBODIMENTS

An embodiment of the angular velocity detecting apparatus according to the present invention will be described with reference to the accompanying drawings. In the following description the same elements will be denoted by the same reference numerals and redundant description will be omitted.

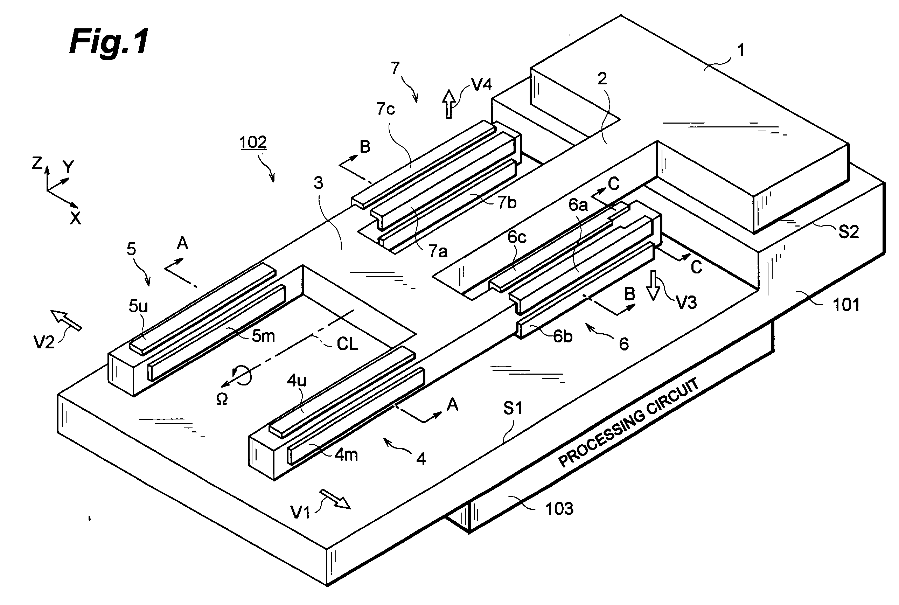

Fig. 1 shows the angular velocity detecting apparatus according to the embodiment. This apparatus comprises a vibrator 102 fixed at one end to a surface of a support stage 101 and a processing circuit 103 attached to the back surface of the support stage 101. In the following description, a direction directed from the back surface to the front surface of the support stage 101 is defined as an "up" direction, while a direction opposite thereto as a "down" direction.

The support stage 101 has a principal surface S1 and a setting surface S2 spaced a predetermined distance apart upward from the principal surface S1, so that a level difference is formed at the border between the principal surface S1 and the setting surface S2.

The vibrator 102 has a fixed portion 1 at one end thereof and the fixed portion 1 is fixed to the setting surface S2 of the support stage 101 with an adhesive or the like. The vibrator 102 is comprised of the fixed portion 1, a supporting rod 2 extending from the fixed portion 1 in the direction directed from the setting surface S2 to the principal surface S1 while maintaining a predetermined clearance to the support stage 101, a base 3 supported by the supporting rod 2, a pair of vibrating bars for vibration 4, 5 extending from the base 3 and away from the fixed portion 1, and a pair of vibrating bars for detection 6, 7 extending from the base 3 and toward the fixed portion 1.

Further, the fixed portion 1, supporting rod 2, base 3, and vibrating bars 4 to 7 are comprised of an integral piezoelectric crystal member and a plurality of electrodes attached to this piezoelectric crystal member. A material for the piezoelectric crystal member according to the present embodiment is quartz.

Natural quartz is normally a columnar crystal, in which the vertical center axis of this columnar crystal is defined as the Z-axis or as the optical axis and a line passing the Z-axis and normally intersecting each surface of the columnar crystal as the Y-axis or as the mechanical axis. Further, a line passing the Z-axis and perpendicularly intersecting the vertical ridges of this columnar crystal is defined as the X-axis or as the electrical axis. The quartz used for this vibrator 102 is artificial quartz, but the structure thereof is the same as natural quartz. Thus, the description follows the above convention as to the directions of the respective axes. Namely, the thickness direction of the vibrator 102 is defined as the Z-axis and the axes perpendicular to this Z-axis and normal to each other are defined as the Z-axis and as the Y-axis, respectively.

The vibrator 102 will be described in further detail based on this convention.

The fixed portion 1 has a lower surface fixed to the setting surface S2 of the setting stage 101. The lower surface has a rectangular shape the longitudinal direction of which extends along the X-axis and the sides of which are defined by the X-axis and Y-axis. The upper surface opposite to the lower surface also has substantially the same shape as the lower surface. External surfaces of the fixed portion 1 located between the upper surface and the lower surface are defined as side faces of the fixed portion 1. One end of the supporting rod 2 is continuous from one side face of the fixed portion 1 and it extends along the Y-axis from the fixed portion 1. The base 3 is continuous from the other end of the supporting rod 2 and extends along the X-axis.

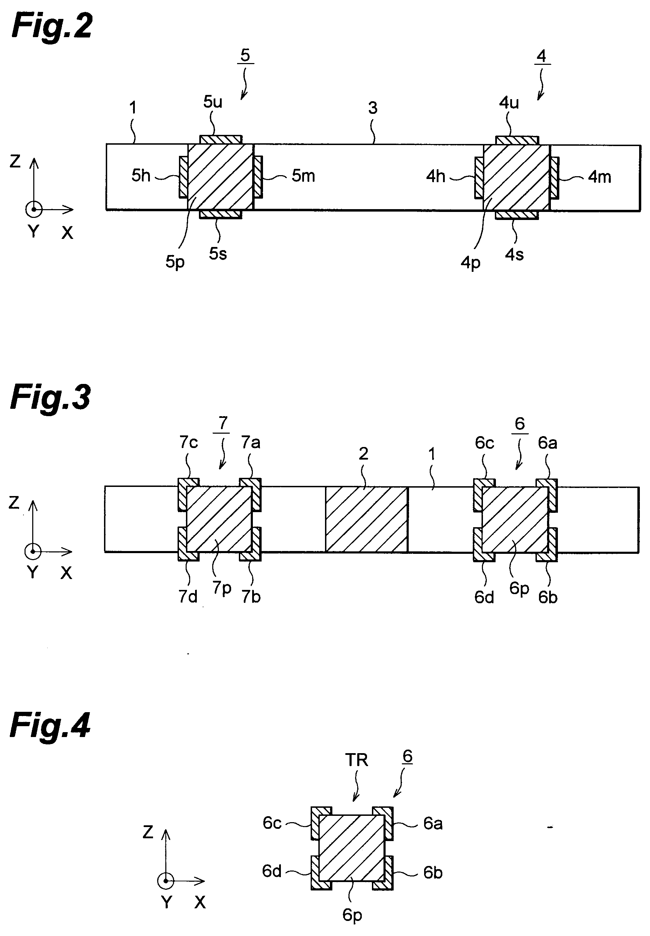

Fig. 2 is a cross-sectional view of the vibrator 102 where the vibrator 102 shown in Fig. 1 is observed along the direction of arrows of line A-A.

The first vibration-use vibrating bar 4 extends along the Y-axis from one end of the base 3 and away from the fixed portion 1, and is composed, as shown in Fig. 1 and Fig. 2, of a piezoelectric crystal portion 4p and, an upper electrode 4u, a lower electrode 4s, a right electrode 4m, and a left electrode 4h fixed to the respective side faces of the piezoelectric crystal portion 4p.

A cross section of the piezoelectric crystal portion 4p normal to the Y-axis is generally a rectangle defined by four sides. In the description, "generally a rectangle" does not mean a precise rectangle mathematically defined, but may mean a substantial quadrangle where an accurate rectangle cannot be formed because of etching upon fabrication of the piezoelectric crystal portion 4p, for example, where a pentagon is formed by bend of one of the four sides. The piezoelectric crystal portion 4p has four side faces including these four sides and being parallel to the Y-axis. Among these side faces of the piezoelectric crystal portion 4p, the lower surface is opposed through a space to the principal surface S1 of the support stage 101 and the upper surface is opposed to the lower surface of the piezoelectric crystal portion 4p. The remaining two side faces of the piezoelectric crystal portion 4p are normal to the upper surface and the lower surface and opposed to each other. Among these two side faces, the one located on the right side when seen from the tip of the vibrating bar 4 is defined as a right side face, while the other located on the left side as a left side face.

The upper electrode 4u is formed only on the upper surface of the piezoelectric crystal portion 4p and extends toward the tip of the vibrating bar 4 from near the border between the base 3 and this vibrating bar 4. The lower electrode 4s is formed only on the lower face of the piezoelectric crystal portion 4p and extends toward the tip of the vibrating bar 4 from near the border between the base 3 and the vibrating bar 4. The right electrode 4m covers a part of the right side face of the piezoelectric crystal portion 4p.

The right electrode 4m extends from near the border between the base 3 and the vibrating bar 4 toward the tip of the vibrating bar 4 along the longitudinal direction of the upper electrode 4u while maintaining a constant clearance to the upper electrode 4u, thereby being physically separated from the upper electrode 4u. The left electrode 4h covers a part of the left side face of the piezoelectric crystal portion 4p.

The left electrode 4h also extends from near the border between the base 3 and the vibrating bar 4 toward the tip of the vibrating bar 4 along the longitudinal direction of the upper electrode 4u as maintaining a constant clearance to the upper electrode 4u, thereby being physically separated from the upper electrode 4u. Each of the electrodes 4h, 4m on the left and right side faces also maintains a constant clearance to the lower electrode 4s, thus being physically separated therefrom.

These electrodes 4u, 4s, 4m, 4h can be formed as being physically separated from each other, by only forming an electrode layer covering the entire surface of the piezoelectric crystal portion 4p and thereafter removing the electrode layer in the regions between the electrodes. Namely, these electrodes can be separated from each other by using the etching process of the photolithography technology. The electrodes 4h and 4m on the left and right side faces each are positioned so as to generate electric field components perpendicular to a YZ plane passing the center of the piezoelectric crystal portion 4p and opposite to each other in the piezoelectric crystal portion 4p with application of voltage between the upper and lower electrodes 4u, 4s.

The second vibration-use vibrating bar 5 extends along the Y-axis from one end of the base 3 and away from the fixed portion 1, and is comprised, as shown in Fig. 1 and Fig. 2, of a piezoelectric crystal portion 5p and, an upper electrode 5u, a lower electrode 5s, a right electrode 5m, and a left electrode 5h fixed to the respective side faces of the piezoelectric crystal portion 5p. The shortest distance between a YZ plane including the center line CL of the supporting rod 2 and the second vibration-use vibrating bar 5 is equal to the shortest distance between this plane and the first vibration-use vibrating bar 4. Namely, the vibrating bars for vibration 4 and 5 are located at positions symmetric with respect to the supporting rod 2. Since the second vibration-use vibrating bar 5 has the same structure as the first vibration-use vibrating bar 4, description is omitted of the details of the structure.

The vibrating bars for detection 6 and 7 are described next.

Fig. 3 is a cross-sectional view of the vibrator 102 where the vibrator 102 shown in Fig. 1 is observed along the direction of arrows of line B-B.

The first detection-use vibrating bar 6 extends along the Y-axis from one end of the base 3 and toward the fixed portion 1 and is comprised, as shown in Fig. 1 and Fig. 3, of a piezoelectric crystal portion 6p and, a right upper electrode 6a, a right lower electrode 6b, a left upper electrode 6c, and a left lower electrode 6d covering the respective corner portions of the piezoelectric crystal portion 6p. The longitudinal direction of the first detection-use vibrating bar 6 is coincident with the longitudinal direction of the first vibration-use vibrating bar 4, and these vibrating bars 6 and 4 are adjusted in their shape and weight or the like so as to transmit at least Z-directional vibration.

A cross section of the piezoelectric crystal portion 6p normal to the Y-axis is generally a rectangle defined by four sides. The piezoelectric crystal portion 6p has four side faces respectively including these four sides and being parallel to the Y-axis, and the four corner portions of the piezoelectric crystal portion 6p are defined by intersection of the four side faces. Among these side faces of the piezoelectric crystal portion 6p, the lower face is opposed through a space to the principal surface S1 of the support stage 101 while the upper face is opposed to the lower face of the piezoelectric crystal portion 6p. The remaining two side faces of the piezoelectric crystal portion 6p are perpendicular to the upper face and to the lower face and opposed to each other. Among these two side faces, the one located on the right side when seen from the tip of the vibrating bar 4 is defined as a right side face and the other located on the left side as a left side face.

The right upper electrode 6a covers only a corner portion defined by intersection between the upper face and the right side face of the piezoelectric crystal portion 6p and the right lower electrode 6b covers only a corner portion defined by intersection between the lower face and the right side face of the piezoelectric crystal portion 6p. Further, the left upper electrode 6c covers only a corner portion defined by intersection between the upper face and the left side face of the piezoelectric crystal portion 6p, and the left lower electrode 6d covers only a corner portion defined by intersection between the lower face and the left side face of the piezoelectric crystal portion 6p. The electrodes 6a to 6d each extend from near the border between the base 3 and the vibrating bar 6 toward the tip of the vibrating bar 6 while maintaining a predetermined clearance to each other, thereby being physically separated from each other.

Fig. 4 is a cross-sectional view of the vibrating bar 6 where the vibrating bar 6 shown in Fig. 1 is observed along the direction of arrows of line C-C.

As the mass of the vibrating bar 6 changes, the natural frequency of the vibrating bar changes. Changes of the mass and shape of electrode affect the natural frequency of the vibrating bar 6 more on the tip side of the vibrating bar 6 than on the root side. Since stress acting on the tip side is smaller than that on the root side, the detection sensitivity is less affected by the changes of the mass and shape of electrode on the tip side of the vibrating bar 6 than on the root side. Accordingly, in order to adjust the natural frequency, the right upper electrode 6a and left upper electrode 6c on the tip side from the position of the center of gravity of the vibrating bar 6 have a region TR formed by removing their parts by trimming, as shown in Fig. 1 and Fig. 4. In other words, the clearance between the right upper electrode 6a and the left upper electrode 6c at the tip of the vibrating bar 6 is greater than that on the root side of the vibrating bar 6. Such removal of electrode can be effected using a laser processing machine.

The second detection-use vibrating bar 7 extends along the Y-axis from one end of the base 3 and toward the fixed portion 1 and is comprised, as shown in Fig. 1 and Fig. 3, of a piezoelectric crystal portion 7p and, a right upper electrode 7a, a right lower electrode 7b, a left upper electrode 7c, and a left lower electrode 7d covering the respective corner portions of the piezoelectric crystal portion 7p. The shortest distance between the YZ plane including the center line CL of the supporting rod 2 and the second detection-use vibrating bar 7 is equal to the shortest distance between this plane and the first detection-use vibrating bar 6. Namely, these vibrating bars for detection 6 and 7 are located at positions symmetric with respect to the supporting rod 2, in the same manner as the vibrating bars for vibration 4 and 5 were.

As for the second detection-use vibrating bar 7, the electrodes are not removed on the tip side of this vibrating bar 7, different from the first detection-use vibrating bar 6. Except for this point, the second detection-use vibrating bar 7 has the same structure as the first detection-use vibrating bar 6, and therefore, description is omitted of the details of the structure. In order to vibrate each vibrating bar 4 to 7 stably, the vibrator 102 is desirably set in an airtight vessel the internal pressure of which is set lower than the atmospheric pressure.

Next described is excitation of the vibrator 102 and detection of angular velocity.

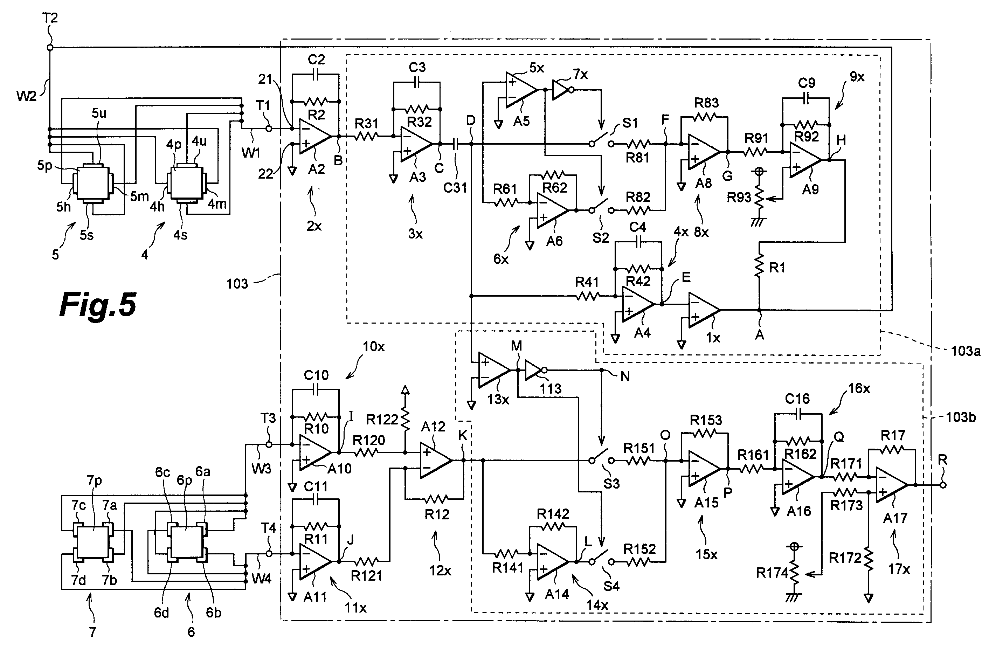

First described is the relationship of connection of each electrode. Fig. 5 shows the relation of connection of the electrodes 4u, 4s, 4m, 4h, 5u, 5s, 5m, 5h, 6a to 6d, 7a to 7d of the respective vibrating bars 4 to 7, and the processing circuit 103 electrically connected to these electrodes.

The upper and lower electrodes 4u, 4s of the vibration-use vibrating bar 4 and the left and right electrodes 5h, 5m of the vibration-use vibrating bar 5 are electrically connected through wire W1 to terminal T1. Further, the left and right electrodes 4h, 4m of the vibration-use vibrating bar 4 and the upper and lower electrodes 5u, 5s of the vibration-use vibrating bar 5 are electrically connected through wire W2 to terminal T2.

Further, the right upper electrode 6a and left lower electrode 6d of the detection-use vibrating bar 6 and the right lower electrode 7b and left upper electrode 7c of the detection-use vibrating bar 7 are connected through wire W3 to terminal T3. The right lower electrode 6b and left upper electrode 6c of the detection-use vibrating bar 6 and the right upper electrode 7a and left lower electrode 7d of the detection-use vibrating bar 7 are connected through wire W4 to terminal T4. These wires W1 to W4 are desirably formed by the photolithography technology so as to be routed through the region on the supporting rod 2 of the vibrator 102 shown in Fig. 1 up to the fixed portion 1.

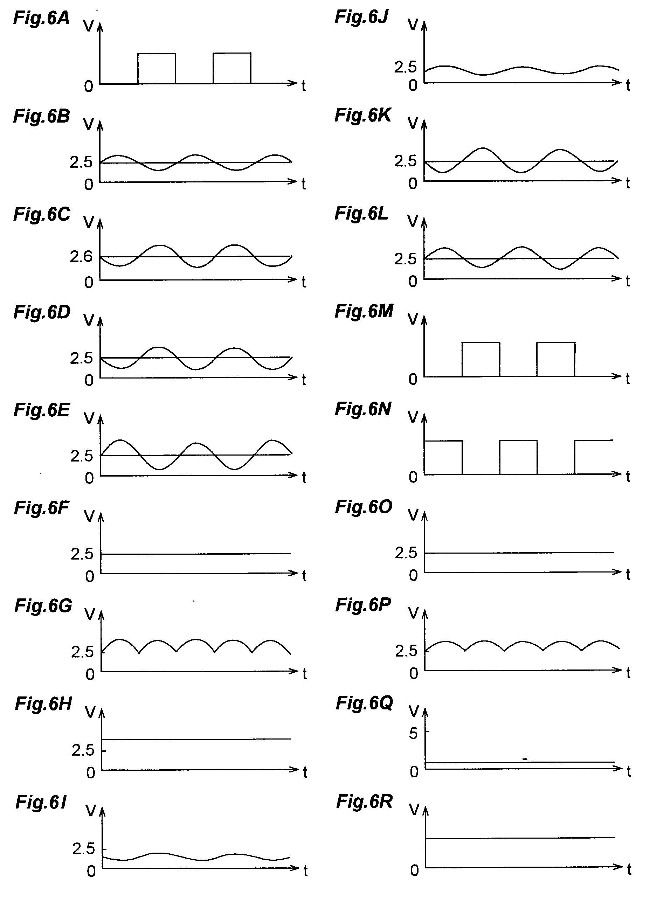

Next described is excitation of the vibration-use vibrating bars 4 and 5. Figs. 6A to 6R are timing charts to show waveforms of voltages at respective nodes of the processing circuit 103. Fig. 6A to 6R show the waveforms of voltages at nodes A to R of Fig. 5. The following description will refer to Figs. 6A to 6R with necessity.

The processing circuit (the circuit) 103 is comprised of an excitation drive circuit (the excitation means) 103a for giving the terminal T2 the potential varying periodically, a current-voltage converting circuit (the potential fixing means) 2x for converting a current signal from the terminal T1 to a voltage signal, charge amplifiers 10x, 11x each for converting a current signal from the terminal T3 or T4 to a voltage signal, a differential amplifier 12x for outputting a difference between the voltage signals output from these charge amplifiers 10x, 11x, and a detecting circuit (the detecting means) 103b for detecting a voltage signal output from the differential amplifier 12x.

The excitation drive circuit 103a is composed of comparator 1x, inverting amplifiers 3x, 4x, capacitor C31, comparator 5x, inverting amplifier 6x, inverter 7x, inverting amplifier 8x, and integrating circuit 9x.

The comparator 1x is configured of an operational amplifier having an inverting input terminal and a non-inverting input terminal and the non-inverting input terminal is fixed at the predetermined voltage level 2.5 V. The comparator 1x outputs a voltage signal of high level with input of a voltage signal lower than this voltage level, but outputs a voltage signal of low level with input of a voltage signal higher than the predetermined voltage level.

Since sine-wave voltage $V_E$ with the amplitude center at 2.5 V as shown in Fig. 6E is supplied to the inverting input terminal of comparator 1x, the comparator 1x outputs square-wave voltage $V_A$ synchronized with this sine-wave voltage $V_E$. Fig. 6A shows the waveform of the square-wave voltage $V_A$. Namely, the comparator 1x applies the potential synchronized with the alternating voltage input and varying at the predetermined period to the terminal T2. Accordingly, the potential varying at the predetermined repetition cycles is given to the left and right electrodes 4h, 4m of the vibration-use vibrating bar 4 and to the upper and lower electrodes 5u, 5s of the vibration-use vibrating bar 5. The peak value of the square-wave voltage $V_A$ is $A_H$. Such feedback control is carried out as to keep this peak value $A_H$ of the square-wave voltage $V_A$ constant by an amplitude fixing circuit comprised of the elements 5x to 9x. Here, the peak value $A_H$ is set at 2.5 V or higher.

The current-voltage converting circuit 2x is composed of an operational amplifier A2 having inverting input terminal 21, non-inverting input terminal 22, and an output terminal indicated by node B, feedback resistor R2 connected between the inverting input terminal 21 and the output terminal B, and capacitor C2 connected in parallel to the resistor R2. The inverting input terminal 21 of the operational amplifier A2 is connected to the terminal T1 and the potential of the non-inverting input terminal 22 is fixed at 2.5 V. The inverting input terminal 21 and non-inverting input terminal 22 are in the imaginal short state, so that the potential of the inverting input terminal 21 is equal to that of the non-inverting input terminal 22. Since the potential of the non-inverting input terminal 22 is fixed at 2.5 V, the potential of the inverting input terminal 21 is 2.5 V.

The upper and lower electrodes 4u, 4s of the vibration-use vibrating bar 4 and the left and right electrodes 5h, 5m of the vibration-use vibrating bar 5 are connected through the terminal T1 to the inverting input terminal 21 of the operational amplifier A2. Therefore, the potential of these electrodes 4u, 4s, 5h, 5m is fixed at 2.5 V. On the other hand, the square-wave voltage $V_A$, i.e., the potential varying up and down with respect to 2.5 V, is given from the comparator 1x through the terminal T2 to the electrode group 4h, 4m, 5u, 5s of the vibration-use vibrating bars 4 and 5. Thus placed between the electrode group 4u, 4s, 5h, 5m and the electrode group 4h, 4m, 5u, 5s is the voltage between the square-wave voltage $V_A$ and 2.5 V, that is, the square-wave voltage $V_A$ the potential of which varies up and down with respect to 2.5 V. In other words, the excitation means 103a gives the electrode group 4h, 4m, 5u, 5s the potential varying at the predetermined period and the potential fixing means 2x fixes the potential of electrode group 4u, 4s, 5h, 5m at the predetermined value.

When the square-wave voltage $V_A$ is applied between the electrode group 4u, 4s, 5h, 5m and the electrode group 4h, 4m, 5u, 5s, the vibration-use vibrating bars 4 and 5 are deflected in mutually opposite directions along the X-axis by the inverse piezoelectric effect, as indicated by arrows V1 and V2 of Fig. 1. Charge $Q_1$ induced in the central areas of the side faces of the vibration-use vibrating bars 4 and 5 with the deflection is converted to a voltage signal by the current-voltage converting circuit 2x. Specifically, the electric current flowing from the electrodes 4u, 4s, 5m, 5h into the inverting input terminal 21 flows through this resistor R2 to the output terminal B, so that this electric current is subjected to current-voltage conversion by a voltage drop caused by the resistor R2 and capacitor C2.

Letting $Q_1(t)$ be the charge at time t, the voltage $V_B$ output from the current-voltage converting circuit 2x is given by the following equation. The waveform of the alternating voltage $V_B$ is shown in Fig. 6B.

$$V_B = j\omega Q_1(t) \cdot R2/(1 + j\omega C2 \cdot R2) \quad \text{(Eq. 1)}$$

In the equation, j is the unit of imaginary number, $\omega$ the angular frequency, R2 the resistance of resistor R2, and C2 the capacitance of capacitor C2. Here, if the capacitance C2 =0, the phase of $V_B$ lags 90° from $Q_1(t)$ and the amplitude is proportional to the resistance R2. Stray capacitance of 1 or more pF exists between wires forming the current-voltage converting circuit 2x.

In the current-voltage converting circuit 2x according to the present embodiment, the capacitance C2 =10 pF, ignoring this stray capacitance. It is also assumed that the natural frequency in the directions along the X-axis of the vibration-use vibrating bars 4 and 5 is 8500 Hz and that the repetition cycles of the square-wave voltage $V_A$ output from the comparator 1x are coincident therewith.

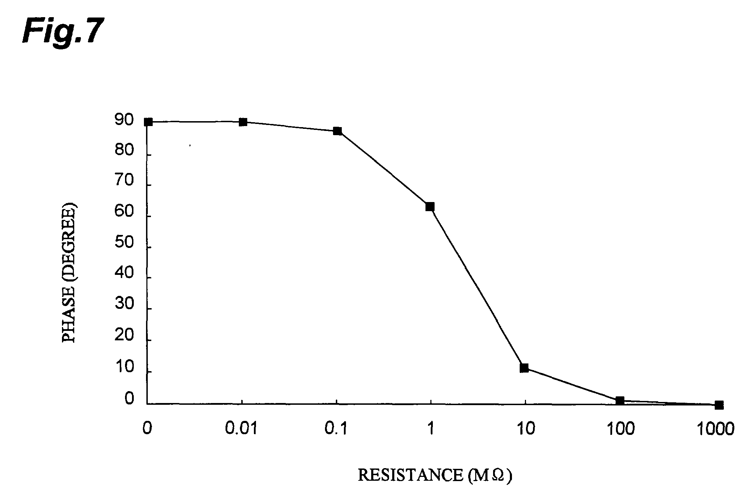

Fig. 7 is a graph to show the relationship between resistance R2 and phase of voltage $V_B$. As apparent from Fig. 7, the phase is approximately 90° (at least 89° or more) when the resistance R2 is 10 or less kΩ.

The voltage signal output from the current-voltage converting circuit 2x is supplied to the inverting amplifier 3x. The inverting amplifier 3x is comprised of operational amplifier A3 having an inverting input terminal, a non-inverting input terminal, and an output terminal indicated by node C, resistor R31 connected between the inverting input terminal and the node B, resistor 32 connected between the inverting input terminal and the output terminal C, and capacitor C3 connected in parallel to the resistor R32. The potential of the non-inverting input terminal of the operational amplifier A3 is fixed at 2.5 V. Since the sine-wave voltage $V_B$ the phase of which lags 90° is output from the current-voltage converting circuit 2x, the inverting amplifier 3x outputs the sine-wave voltage $V_C$ with the phase inverted relative to the voltage $V_B$ is output with input of this voltage $V_B$ into the inverting amplifier 3x. The waveform of the alternating voltage $V_C$ is shown in Fig. 6C.

The output voltage $V_C$ from the inverting amplifier 3x is supplied through capacitor C31 to node D. The capacitor C31 removes the offset component of the alternating voltage $V_C$. The waveform of the alternating voltage $V_D$ at the node D is shown in Fig. 6D. The amplitude of the alternating voltage $V_D$ is the same as the amplitude of $V_C$. A 5 V-power supply not illustrated supplies the voltage through a switch not illustrated to each operational amplifier forming the processing circuit 103. When this switch is turned on, the processing circuit 103 operates, but the transient phenomenon upon on of the switch increases the above offset component so as to fix the output from comparator 1x at the high level or at the low level. Since the present processing circuit 103 is arranged to remove this offset component by the capacitor C31, this output fixing phenomenon can be prevented.

Connected to the node D are the inverting amplifier 4x and the amplitude fixing circuit comprised of the comparator 5x, inverting amplifier 6x, inverter 7x, inverting amplifier 8x, and integrating circuit 9x. The comparator 5x includes operational amplifier A5 having a non-inverting input terminal connected to the node D and an inverting input terminal the potential of which is fixed at 2.5 V. The comparator 5x outputs a voltage signal of high level with input of a voltage signal higher than 2.5 V and outputs a voltage signal of low level with input of a voltage signal lower than 2.5 V. Switch S1 is connected through inverter 7x to the output terminal of comparator 5x. The switch S1 becomes on with input of the voltage signal of high level and becomes off with input of the voltage signal of low level. The switch S1 of this type is, for example, a field effect transistor which undergoes on/off control by the voltage applied to the gate thereof. When the sine-wave voltage output from the node D is lower than 2.5 V, the comparator 5x outputs the voltage signal of low level and thus the inverter 7x outputs the voltage signal of high level. When the voltage signal of high level is supplied to the switch S1, this switch S1 becomes on, so that the voltage signal $V_D$ at the node D passes the switch S1 as it is.

The inverting amplifier 6x has resistor R61, operational amplifier A6 having an inverting input terminal connected through the resistor R61 to the node D and a non-inverting input terminal the potential of which is fixed at 2.5 V, and resistor R62 connected between the inverting input terminal and the output terminal of operational amplifier A6. When the sine-wave voltage $V_D$ is supplied from the node D to the inverting amplifier 6x, the inverting amplifier 6x inverts the phase thereof and outputs the resultant. Switch S2 having the same structure as switch S1 is connected to the output terminal of the inverting amplifier 6x. When the sine-wave voltage output from the node D is higher than 2.5 V, the comparator 5x outputs the voltage signal of high level and thus the inverter 7x outputs the voltage signal of low level, thus disconnecting the switch S1. Since at this time the voltage signal of high level is supplied to the switch S2, the switch S2 becomes on to let the voltage signal with the inverted phase from the voltage signal $V_D$ pass the switch S2. Therefore, the voltage signals having passed the switches S1, S2 each pass resistor R81 or R82 to be combined at node F, thus effecting full-wave rectification of the sine-wave voltage $V_D$.

The inverting amplifier 8x is connected to the node F. The inverting amplifier 8x includes operational amplifier A8 having an inverting input terminal connected to the node F and a non-inverting input terminal the potential of which is fixed at 2.5 V, and resistor R83 connected between the inverting input terminal and the output terminal, indicated by node G, of the operational amplifier A8. The potential of node F is 2.5 V because of imaginary short and the waveform of this voltage $V_F$ is shown in Fig. 6F. The inverting amplifier 8x inverts the phase of the voltage signal input and outputs the resultant. Accordingly, the voltage signal $V_G$ as a result of inversion of the phase of sine-wave voltage $V_D$ after the full-wave rectification is output from the node G. The waveform of this voltage $V_G$ is shown in Fig. 6G.

The integrating circuit 9x is connected to the node G. The integrating circuit 9x includes resistor R91 connected to the node G, operational amplifier A9 having an inverting input terminal connected through the resistor R91 to the node G and a non-inverting input terminal connected through resistor R93 to the ground and to the 5 V-power supply, resistor R92 connected between the inverting input terminal and the output terminal, indicated by node H, of the operational amplifier A9, and capacitor C9 connected in parallel to the resistor R92. The potential $V_1$ of the non-inverting input terminal of the operational amplifier A9 is set as higher than 2.5 V. When effective value $V_g$ of AC component of the voltage $V_G$ is larger than this potential $V_1$, i.e., when the amplitude of vibration of the vibration-use vibrating bars 4 and 5 becomes larger, the integrating circuit 9x outputs a voltage signal $V_H$ as shown in Fig. 6H, which is smaller by a voltage proportional to the difference between $V_1$ and $V_g$ than $V_1$. At this time, the peak value $A_H$ of the potential $V_A$ is decreased at the output terminal A of comparator 1x connected to the node H through pull-up resistor R1 having a relatively small resistance. Since the pull-up resistor R1 does not affect the oscillation condition, the voltage $V_A$ with large amplitude can be applied to the vibrating bars 4 and 5 by setting the resistance thereof low.

The inverting input terminal of comparator 1x is connected to the output terminal of the inverting amplifier 4x. The inverting amplifier 4x includes resistor R41, operational amplifier A4 having an inverting input terminal to which the sine-wave voltage $V_D$ is supplied through the resistor R41 from the node D and a non-inverting input terminal the potential of which is fixed at 2.5 V, and resistor R42 and capacitor C4 connected between the output terminal and the inverting input terminal of the operational amplifier A4. When the sine-wave voltage $V_D$ is supplied from the node D to the inverting amplifier 4x, the inverting amplifier 4x outputs the sine-wave voltage $V_E$ as inverting the phase of voltage $V_D$. As described above, the comparator 1x outputs the square-wave voltage $V_A$ synchronized with this sine-wave voltage $V_E$.

The amplitude of vibration of the vibration-use vibrating bars 4 and 5 is nearly proportional to the peak value $A_H$. As the amplitude of vibration of the vibration-use vibrating bars 4 and 5 becomes larger, the peak value $A_H$ of the output voltage from the output terminal A of comparator 1x becomes lower. Accordingly, when the amplitude of vibration of vibrating bars 4 and 5 becomes larger, the vibrating bars 4 and 5 are subjected to such feedback control as to decrease the amplitude. Similarly, when the amplitude of vibration of the vibration-use vibrating bars 4 and 5 becomes smaller, the peak value $A_H$ of the output terminal A of comparator 1x becomes higher and thus the vibrating bars 4 and 5 are subjected to such feedback control as to increase the amplitude.

As described above, the vibration-use vibrating bars 4 and 5 are vibrated stably by the circuitry comprised of the current-voltage converting circuit 2x and the excitation drive circuit 103a. Since the square-wave voltage $V_A$ is generated from the charge representing the actual excitation, even if the piezoelectric crystal portions 4p and 5p change depending upon the temperature or the like, the square-wave voltage $V_A$ can follow this change. The waveform of voltage $V_A$ may be of a sine wave, but, if it is of a square wave, the vibrating bars 4 and 5 can be vibrated in the primary mode of vibration. Specifically, with power on of the processing circuit 103, vibration starts from the noise component of voltage $V_A$. At this time, because the impedance is low at high frequencies, the vibrating bars 4 and 5 tend to oscillate at high frequencies, so that the vibrating bars 4 and 5 are likely to oscillate in the higher vibration modes. If $V_A$ is not the square-wave voltage, the vibrating bars 4 and 5 will start oscillating in the higher vibration modes to leave the possibility of oscillation in the higher modes, though the vibration of vibrating bars 4 and 5 is easy to become vibration in the primary vibration mode with high Q value. When a square wave is expanded by Fourier series, it is seen that the square wave is superposition of plural harmonics on the fundamental wave. Therefore, the vibrating bars 4 and 5 start vibrating as induced by higher harmonic components, but the vibration mode thereof can transfer through the vibration modes corresponding to the harmonic components between the fundamental wave component and the higher harmonics to the primary mode in which they are easiest to vibrate.

Next described is detection of angular velocity. When the vibrator 102 is rotated in the direction indicated by the arrow $\Omega$ of Fig. 1 with the vibration-use vibrating bar pair 4 and 5 vibrating at velocity V along the X-axis directions, the Coriolis' force proportional to $V \times \Omega$ acts along the Z-axis direction on the vibration-use vibrating bars 4 and 5, so that the vibration-use vibrating bars 4 and 5 each also vibrate in the directions along the Z-axis.

On the other hand, since the detection-use vibrating bars 6 and 7 are mechanically coupled respectively with the vibration-use vibrating bars 4 and 5 to the extent that vibration in the Z-axis directions is transmitted, the detection-use vibrating bars 6 and 7 vibrate along the Z-axis with the vibration of the vibration-use vibrating bars 4 and 5 in the Z-axis directions. The detection-use vibrating bars 6 and 7 vibrate in mutually opposite phases, as shown by the arrows V3 and V4 of Fig. 1, i.e., they vibrate so that velocity vectors of the respective vibrating bars 6 and 7 in the Z-axis directions at an arbitrary time during the vibration become opposite to each other.

While the detection-use vibrating bars 6 and 7 vibrate as deflected in the Z-axis directions because of the Coriolis' force, the charge is generated by the piezoelectric effect at the all corners of the piezoelectric crystal portions 6p, 7p of the detection-use vibrating bars 6, 7 shown in Fig. 5. The charge of these is efficiently detected by the electrodes 6a to 6d and 7a to 7d covering the corners.

As described previously, the electrode group 6a, 6d, 7b, 7c and the electrode group 6b, 6c, 7a, 7d of the detection-use vibrating bars 6 and 7 are connected through the terminals T3 and T4 to the charge amplifiers 10x and 11x, respectively.

The charge amplifier 10x is composed of operational amplifier A10 having an inverting input terminal connected to the terminal T3 and a non-inverting input terminal the potential of which is fixed at 2.5 V, resistor R10 connected between the inverting input terminal and the output terminal indicated by node I, and capacitor C10 connected in parallel to the resistor R10. The inverting input terminal of the operational amplifier A10 is connected to the terminal T3 and the potential of the non-inverting input terminal is fixed at 2.5 V.

The structure of the charge amplifier 11x is the same as that of the charge amplifier 10x. The charge amplifier 11x is composed of operational amplifier A11 having an inverting input terminal connected to the terminal T4 and a non-inverting input terminal the potential of which is fixed at 2.5 V, resistor R11 connected between the inverting input terminal and the output terminal indicated by node J, and capacitor C11 connected in parallel to the resistor R11. The inverting input terminal of the operational amplifier A11 is connected to the terminal T4 and the potential of the non-inverting input terminal is fixed at 2.5 V.

The charge $Q_2$ generated at the corners of the piezoelectric crystal portions 6p, 7p by the vibration of the detection-use vibrating bars 6, 7 in the Z-axis directions because of the Coriolis' force is converted into a voltage signal by these charge amplifiers 10x and 11x.

Letting $Q_2(t)$ be the charge at time t, the voltage $V_I$ output from the charge amplifier 10x is given by the following equation. The waveform of the alternating voltage $V_I$ is shown in Fig. 6I.

$$V_I = j\omega Q_2(t) \cdot R2/(1 + j\omega C10 \cdot R10) \quad \text{(Eq. 2)}$$

In the equation, R10 is the resistance of the resistor R10 and C10 the capacitance of capacitor C10. Here, if the resistance R10 = infinite, Eq. 2 is given by the following equation.

$$V_I = Q_2(t)/C10$$

This means that if the resistance R10 = infinite the phase of voltage $V_I$ is coincident with that of $Q_2(t)$. Insulation resistance of the substrate on which the charge amplifier 10x is made is very large and this insulation resistance varies depending upon the temperature or the like. In order to decrease the influence of this variation, the value of R10 needs to be small, but, in the case of the resistance being zero, the potential of the input terminal of the operational amplifier A10 becomes unstable. Therefore, the resistance R10 is desirably as high as possible, and an appropriate value is approximately 30 M$\Omega$. The charge amplifier 10x according to the present embodiment is thus arranged to have, for example, the resistance R10 = 30 M$\Omega$. Further, the Z-directional natural frequency of the detection-use vibrating bars 6 and 7 is set at 8500 Hz. The present embodiment is arranged so that the natural frequency in the X-axis directions is made coincident with that in the Z-axis directions, but they may be different from each other. Since the resistor and capacitor R10, C10, R11, C11 of the charge amplifiers 10x and 11x function as a low-pass filter, they can remove high-frequency noise components in the signals supplied to these amplifiers 10x and 11x.

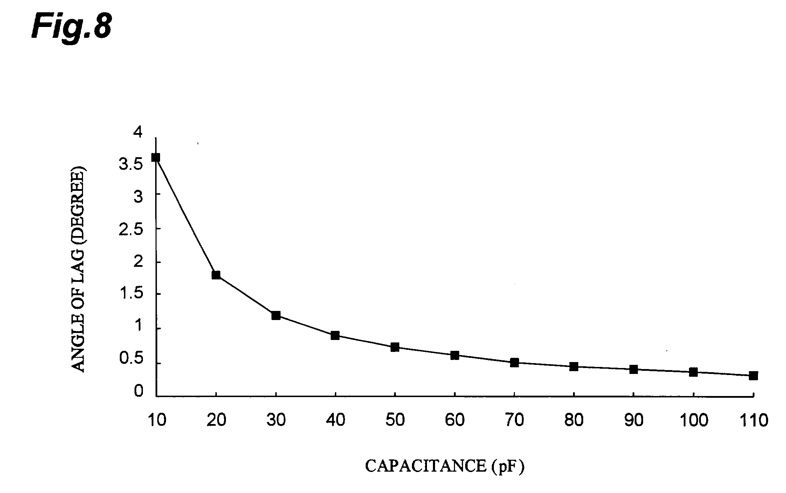

Fig. 8 is a graph to show the relationship between capacitance C10 and phase of voltage $V_I$. As apparent from Fig. 8, when the capacitance C10 is 70 or more pF, the phase is almost 0° (0.5° or less). The amplitude center of the alternating voltage $V_I$ output from the charge amplifier 10x becomes lower than 2.5 V, because the resistance R10 is high. Since the structure of the charge amplifier 11x is the same as that of the charge amplifier 10x, voltage signal $V_J$, which is inversion of only the phase of $V_I$, is output. The waveform of the alternating voltage $V_J$ is shown in Fig. 6J.

The magnitude of the Coriolis' force is nearly proportional to the velocity of vibration of the vibration-use vibrating bars 4 and 5. The velocity of the vibration becomes maximum at the neutral position of the vibration-use vibrating bars 4 and 5. Accordingly, when the velocity of the vibration of the vibration-use vibrating bars 4 and 5 is maximum, vibration resulting from the largest Coriolis' force is transmitted to the detection-use vibrating bars 6 and 7 and the amplitude of the vibration of the detection-use vibrating bars 6 and 7 becomes maximum. This means that when the vibration-use vibrating bars 4 and 5 are at the neutral position, the detection-use vibrating bars 6 and 7 are displaced farthest from the neutral position thereof. In other words, the phase of charge $Q_1(t)$ appearing in the vibration-use vibrating bars 4 and 5 deviates 90° from the phase of charge $Q_2(t)$ appearing in the detection-use vibrating bars 6 and 7, based on the Coriolis' force. On the other hand, the current-voltage converting circuit 2x on the excitation side effects the phase conversion of 90° on the charge $Q_1$, but the charge amplifier 10x on the detection side effects no phase conversion on the charge $Q_2$. Therefore, the phase difference is 180° between the voltages $V_B$ and $V_I$ output from them. Since the phase of the voltage $V_B$ is inverted by the inverting amplifier 3x, the phase of the output voltage $V_C$ of the inverting amplifier 3x is coincident with the phase of the output voltage $V_I$ of the charge amplifier 10x. Although the detection-use vibrating bars 6 and 7 contain vibration components in the X-axis directions, because the electrodes 6a to 6d and 7a to 7d are connected to the terminals T3 and T4 so that their polarities of the charge generated by the vibration in the X-axis directions become opposite, the vibration components in the X-axis directions cancel out each other.

The differential amplifier 12x is connected through resistors R120 and R121 to the output terminals of the charge amplifiers 10x and 11x. The differential amplifier 12x includes operational amplifier A12 having a non-inverting input terminal connected to the resistor R120 and an inverting input terminal connected to the resistor R121, and resistor R12 connected between the inverting input terminal and the output terminal of the operational amplifier A12. The non-inverting input terminal is connected through resistor R122 to the power supply of 2.5 V. The differential amplifier 12x outputs a difference between the input voltage signals $V_I$ and $V_J$. Since the voltage signals $V_I$ and $V_J$ are in the phase-inverted relation, the differential amplifier 12x outputs an alternating voltage signal $V_K$ with the same phase as the voltage signal $V_I$ and with the amplified amplitude. Since the voltage signals $V_I$ and $V_J$ both are sine-wave voltage signals, the waveform of voltage $V_K$ is also of a sine wave. The waveform of the voltage $V_K$ is shown in Fig. 6K.

Connected to the output terminal of the differential amplifier 12x is a synchronous detection circuit composed of comparator 13x, inverter I13, inverting amplifier 14x, switches S3, S4, and resistors R151, R152. The inverting amplifier 14x has resistor R141, operational amplifier A14 having an inverting input terminal connected through the resistor R141 to the node K and a non-inverting input terminal the potential of which is fixed at 2.5 V, and resistor R142 connected between the inverting input terminal and the output terminal of the operational amplifier A14.

When the sine-wave voltage $V_K$ is supplied from the node K to the inverting amplifier 14x, the inverting amplifier 14x inverts the phase thereof and outputs the resultant. The waveform of the voltage $V_L$ output from the inverting circuit 14x is shown in Fig. 6L.

The switch S4 having the same structure as the switch S1 is connected to the output terminal of the inverting amplifier 14x. The structure of switch S3 is also the same as the switch S4. When the sine-wave voltage output from the node D is higher than 2.5 V, the comparator 13x outputs the voltage signal $V_M$ of high level, the inverter I13 thus outputs the voltage signal $V_N$ of low level, and the switch S3 is disconnected. The voltage signals $V_M$ and $V_N$ output from the comparator 13x and from the inverter I13 are shown in Fig. 6M and 6N, respectively.

Since at this time the voltage signal of high level is supplied to the switch S4, the switch S4 becomes on, so that the voltage signal $V_L$ with the inverted phase of the voltage signal $V_K$ passes the switch S4. Similarly, when the sine-wave voltage output from the node D is lower than 2.5 V, the switch S4 is disconnected and the switch S3 becomes on, so that the voltage signal $V_K$ passes the switch S3 as it is.

Since the phase of the voltage signal $V_C$ output from the inverting amplifier 3x on the excitation side is matched with the phase of the voltage signal $V_K$ output from the differential amplifier 12x on the detection side as described above, the voltage signals passing the switch S3, S4 pass the resistor R151, R152, respectively, to be combined at the node O. Namely, the voltage signal $V_K$ output from the differential amplifier 12x on the detection side is synchronously detected with the square-wave voltage signal $V_N$ synchronized with the voltage signal $V_C$ output from the inverting amplifier 3x on the excitation side, and the voltage signal $V_L$ with the inverted phase of the voltage signal $V_K$ is synchronously detected with the square-wave voltage signal $V_M$ synchronized with the voltage signal $V_C$ output from the inverting amplifier 3x on the excitation side. In other words, the voltage component generated based on the Coriolis' force in the sine-wave voltage $V_k$ is subjected to full-wave rectification. Since the phase of the voltage component due to the vibration of the detection-use vibrating bars 6 and 7 in the X-axis directions in the sine-wave voltage $V_k$ deviates 90° from the phase of the voltage component generated based on the Coriolis' force, this synchronous detection makes an integration value thereof zero.

The inverting amplifier 15x is connected to the node O. The inverting amplifier 15x has operational amplifier A15 having an inverting input terminal connected to the node O and a non-inverting input terminal the potential of which is fixed at 2.5 V, and resistor R153 connected between the inverting input terminal and the output terminal of the operational amplifier A15. The voltage of the inverting input terminal of the inverting amplifier 15x indicated by the node O is fixed at 2.5 V by imaginal short. The waveform of the voltage at the node O is shown in Fig. 6O. The inverting amplifier 15x inverts the phase of the voltage signal resulting from the synchronous detection of the sine-wave voltage $V_K$ and its inverted voltage $V_L$ and outputs the resultant. The waveform of the voltage $V_P$ at the output terminal of the inverting amplifier 15x indicated by node P is shown in Fig. 6P.

The integrating circuit 16x is connected to the output terminal of the inverting amplifier 15x indicated by the node P. The integrating circuit 16x includes resistor R161 connected to the node P, operational amplifier A16 having an inverting input terminal connected through the resistor R161 to the node P and a non-inverting input terminal the potential of which is fixed at 2.5 V, resistor R162 connected between the inverting input terminal and the output terminal, indicated by node Q, of the operational amplifier A16, and capacitor C16 connected in parallel to the resistor R162. The integrating circuit 16x inverts and amplifies the effective value of the AC component of the voltage $V_P$ output from the node P and outputs the resultant. The waveform of the DC output voltage $V_Q$ of the integrating circuit 16x is shown in Fig. 6Q. Since the integration value of the signal component based on the vibration component of the detection-use vibrating bars 6 and 7 in the X-axis directions is arranged to become zero by the synchronous detection circuit, this signal component is removed from the DC output voltage $V_Q$ of the integrating circuit 16x.

The amplifying circuit 17x is connected to the output terminal of the integrating circuit 16x indicated by the node Q. The amplifying circuit 17x has resistor R171, operational amplifier A17 having an inverting input terminal connected through the resistor R171 to the node Q and a non-inverting input terminal, and resistor R17 connected between the inverting input terminal and the output terminal of the operational amplifier A17. Further, the non-inverting input terminal of the amplifying circuit 17x is connected through resistor R172 to the power supply of 2.5 V and the non-inverting input terminal is also connected through resistor R173 and variable resistor R174 to the ground and to the power supply of 5 V. The waveform of the voltage $V_R$ at the output terminal of the amplifying circuit 17x is shown in Fig. 6R Offset of the DC output voltage $V_R$ can be adjusted by adjusting the variable resistor R174 of the amplifying circuit 17x.

The magnitude of the DC output voltage $V_R$ is proportional to the magnitude of the Coriolis' force acting on the vibrator 102. This means that when the detection-use vibrating bars 6 and 7 vibrate in the Z-axis directions because of the Coriolis' force, the charge appears in the piezoelectric crystal portions 6p, 7p in proportion to an amount of strain due to the vibration. In other words, the piezoelectric crystal portions 6p, 7p are distorted by the Coriolis' force, whereby a potential difference based on the piezoelectric effect occurs between the electrode group 6a, 6d, 7b, 7c and the electrode group 6b, 6c, 7a, 7d. The differential amplifier 12x outputs the alternating voltage $V_K$ corresponding to this potential difference, the component based on the Coriolis' force in the alternating voltage $V_K$ is subjected to the full-wave rectification by the synchronous detection circuit, and the integrating circuit 16x outputs the voltage signal $V_Q$ proportional to the effective value of the AC component of the full-wave-rectified signal $V_P$ Thus, the Coriolis' force acting on the vibrator 102 can be detected by detecting the DC output voltage $V_R$. The above angular velocity detecting apparatus is mounted on a detected body such as a car and the Coriolis' force acts in proportion to the angular velocity of the detected body, whereupon the present angular velocity detecting apparatus can detect the angular velocity of the detected body.

When the above angular velocity detecting apparatus is mounted on the detected body such as the car, the axis of rotation center of the detected body does not always coincide with the center line CL of the supporting rod 2. However, the angular velocity of the detected body can be detected if the motion of the detected body includes a rotational component about the center line CL of the supporting rod 2.

Further, the vibrator 102 of the present apparatus used the four vibrating bars 4 to 7, but this may be modified to use only two vibrating bars in such an arrangement that the electrodes for excitation and the electrodes for detection are disposed on each of the vibrating bars.

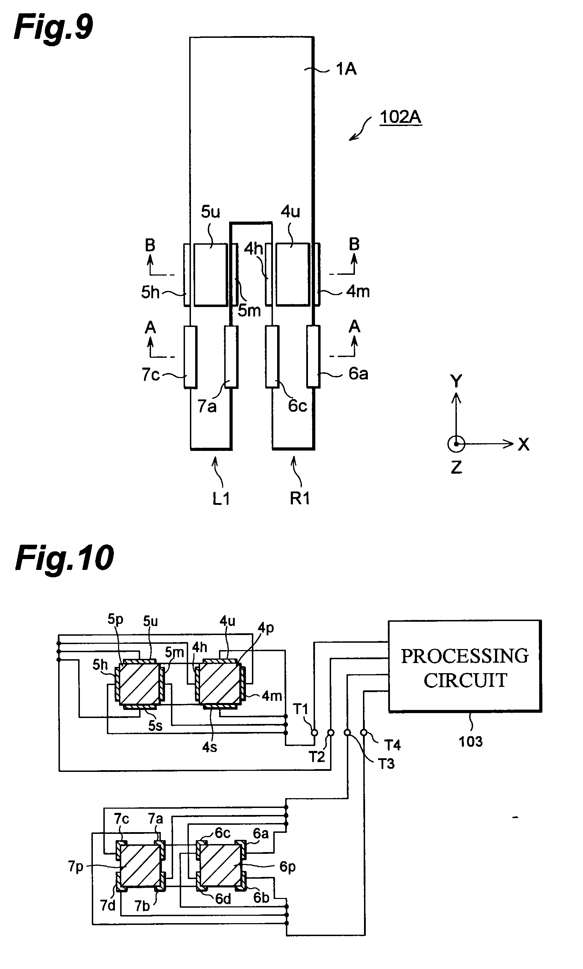

Fig. 9 is a plan view of such vibrator 102A and Fig. 10 shows cross sections of the vibrator 102A obtained by cutting the vibrator 102A along line A-A and line B-B of Fig. 9 and observing it along the arrows and the processing circuit 103 connected thereto. The angular velocity detecting apparatus using this vibrator 102A will be described and the redundant description will be omitted, because the same elements are denoted by the same reference symbols.

The vibrator 102A has a fixed portion 1A and a pair of vibrating bars L1 and R1 spaced a predetermined distance apart from each other and extending in parallel from the fixed portion 1A. The present angular velocity detecting apparatus is the resultant of replacement of the vibrator 102 shown in Fig. 1 with the vibrator 102A and the fixed portion 1A of the vibrator 102A is fixed to the setting surface S2 of the setting stage 101 of Fig. 1. This vibrator 102A is comprised of a plurality of electrodes 4u, 4s, 4m, 4h, 5u, 5s, 5m, 5h, 6a to 6d, and 7a to 7d provided on quartz. The vibrating bars R1 and L1 are arranged so that the vibrating bars R1 and L1 vibrate along the X-axis directions when an alternating voltage is applied from the processing circuit 103 to the electrodes 4u, 4s, 4m, 4h, 5u, 5s, 5m, 5h for excitation. If at this time rotation about the center axis parallel to the Y-axis takes place on the vibrator 102A, the Coriolis' force acts on the vibrating bars R1 and L1, so that the vibrating bars R1 and L1 start vibrating along the Z-axis directions. Since the piezoelectric crystal portions 4p, 5p are mechanically coupled with the piezoelectric crystal portions 6p, 7p, this vibration in the Z-axis directions is transmitted from the piezoelectric crystal portions 4p, 5p to 6p, 7p, so that the piezoelectric crystal portions 6p, 7p are distorted along the Z-axis directions. Accordingly, the processing circuit 103 detects the amount of this distortion through the electrodes 6a to 6d and 7a to 7d for detection, whereby it can detect the Coriolis' force acting on the vibrator 102A.

Further, in the case of the above vibrators 102 and 102A, the piezoelectric crystal portions 4p, 5p for excitation and the piezoelectric crystal portions 6p, 7p for detection are the different portions from each other, but they may be identical portions. In other words, the electrodes for excitation and the electrodes for detection may be placed in a single cross section perpendicular to the Y-axis of the vibrating bars.

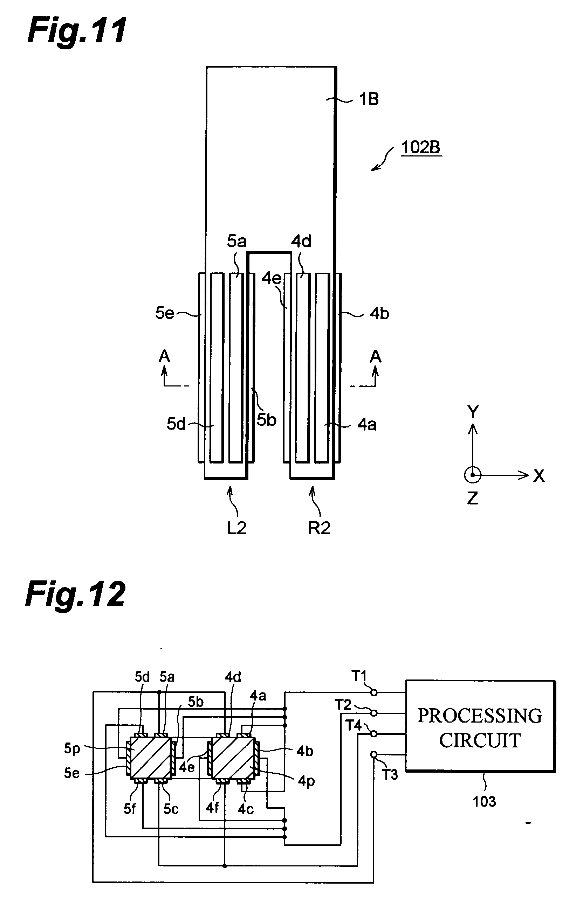

Fig. 11 is a plan view of such vibrator 102B and Fig. 12 shows a cross section of the vibrator 102B obtained by cutting the vibrator 102B along line A-A of Fig. 11 and observing it along the arrows and the processing circuit 103 connected thereto. The angular velocity detecting apparatus using this vibrator 102B will be described and redundant description will be omitted, because the same elements are denoted by the same reference symbols.

The vibrator 102B has a fixed portion 1B and a pair of vibrating bars L2 and R2 spaced a predetermined distance apart from each other and extending in parallel from the fixed portion 1B. The present angular velocity detecting apparatus is the resultant of replacement of the vibrator 102 shown in Fig. 1 with the vibrator 102B and the fixed portion 1B of the vibrator 102B is fixed to the setting surface S2 of the setting stage 101 of Fig. 1.

The vibrating bar R2 is composed of piezoelectric crystal portion 4p made of the piezoelectric crystal and, upper electrodes 4a, 4d, lower electrodes 4c, 4f, right electrode 4b and left electrode 4e fixed to the respective side faces of the piezoelectric crystal portion 4p.

The upper electrodes 4a, 4d are formed only on the upper face of the piezoelectric crystal portion 4p as being physically separated from each other and they extend from near the border between the fixed portion 1B and the vibrating bar R2 toward the tip of the vibrating bar R2. The lower electrodes 4c, 4f are formed only on the lower surface of the piezoelectric crystal portion 4p as being physically separated from each other and they extend from near the border between the fixed portion 1B and the vibrating bar R2 toward the tip of the vibrating bar R2. The right electrode 4b covers a part of the right side face of the piezoelectric crystal portion 4p.

The right electrode 4b extends from near the border between the fixed portion 1B and the vibrating bar R2 toward the tip of the vibrating bar R2 along the longitudinal direction of the upper electrode 4a while maintaining a constant clearance to the upper electrode 4a located right, and it is physically separated from the upper electrode 4a. The left electrode 4e covers a part of the left side face of the piezoelectric crystal portion 4p.

The left electrode 4e also extends from near the border between the fixed portion 1B and the vibrating bar R2 toward the tip of the vibrating bar R2 along the longitudinal direction of the upper electrode 4d as maintaining a constant clearance to the upper electrode 4d located left, and it is physically separated from the upper electrode 4d. Further, each of the electrodes 4b, 4e on the left and right side faces maintains a constant clearance to the lower electrode 4c, 4f and is physically separated therefrom.

These electrodes 4a to 4f are made in such a way that an electrode layer is formed so as to cover the entire surface of the piezoelectric crystal portion 4p and thereafter the electrode layer is removed only in the regions between the electrodes, thereby physically separating these electrodes from each other. Namely, these electrodes 4a to 4f can be separated by using the etching process of the photolithography technology.

The vibrating bar L2 is composed of piezoelectric crystal portion 5p made of the piezoelectric crystal and, upper electrodes 5a, 5d, lower electrodes 5c, 5f, right electrode 5b and left electrode 5e fixed to the respective side faces of the piezoelectric crystal portion 5p. Since the vibrating bar L2 has the same structure as the vibrating bar R2, description of the details of the structure is omitted herein.

The vibrating bars R2 and L2 are arranged so that the vibrating bars R1 and L1 vibrate along the X-axis directions when an alternating voltage is applied from the processing circuit 103 to the electrodes 4a to 4c, 5d to 5f for excitation. When at this time rotation about the center axis parallel to the Y-axis is applied onto the vibrator 102B, the Coriolis' force acts on the vibrating bars R2 and L2, so that the vibrating bars R2 and L2 start vibrating along the Z-axis directions. The piezoelectric crystal portions 4p, 5p are distorted along the Z-axis directions. Accordingly, the processing circuit 103 detects the amount of this distortion through the electrodes 4d to 4f, 5a to 5c for detection, whereby it can detect the Coriolis' force acting on the vibrator 102B. In the present apparatus, because the electrodes for excitation and for detection are provided in a single cross section perpendicular to the Y-axis of the piezoelectric crystal portions 4p, 5p, the number of electrodes is decreased.

A further apparatus may employ the following arrangement of the electrodes for excitation and the electrodes for detection.

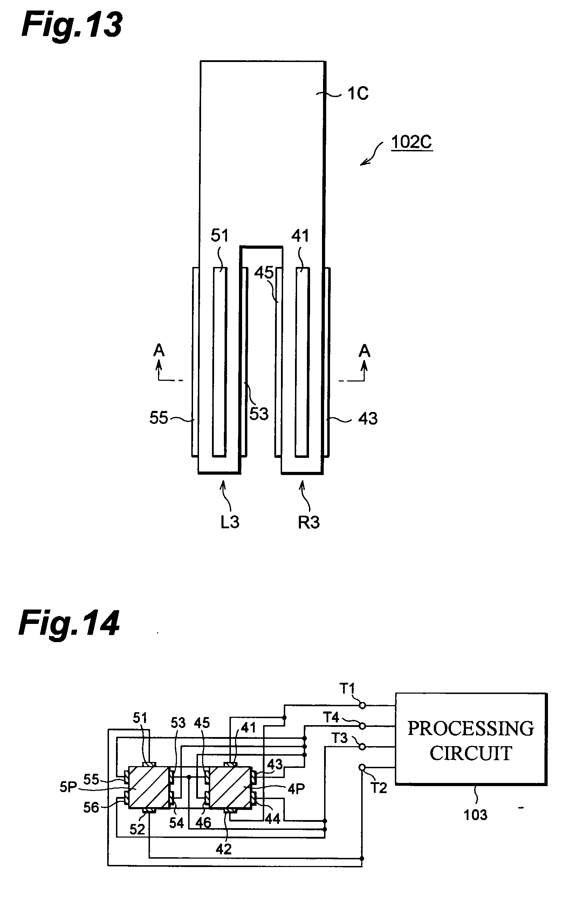

Fig. 13 is a plan view of such vibrator 102C and Fig. 14 shows a cross section of the vibrator 102C obtained by cutting the vibrator 102C along line A-A of Fig. 13 and observing it along the arrows and the processing circuit 103 connected thereto. The angular velocity detecting apparatus using this vibrator 102C will be described and redundant description will be omitted, because the same elements are denoted by the same reference symbols.

The vibrator 102C has a fixed portion 1C and a pair of vibrating bars L3 and R3 spaced a predetermined distance apart from each other and extending in parallel from the fixed portion 1C. The present angular velocity detecting apparatus is the resultant of replacement of the vibrator 102 shown in Fig. 1 with the vibrator 102C and the fixed portion 1C of the vibrator 102C is fixed to the setting surface S2 of the setting stage 101 of Fig. 1.

The vibrating bar R3 is composed of piezoelectric crystal portion 4p made of the piezoelectric crystal and, upper electrode 41, lower electrode 42, right electrodes 43, 44 and left electrodes 45, 46 fixed to the respective side faces of the piezoelectric crystal portion 4p.

The upper electrode 41 is formed only on the upper face of the piezoelectric crystal portion 4p and extends from near the border between the fixed portion 1C and the vibrating bar R3 toward the tip of the vibrating bar R3. The lower electrode 42 is formed only on the lower face of the piezoelectric crystal portion 4p and extends from near the border between the fixed portion 1C and the vibrating bar R3 toward the tip of the vibrating bar R3. The right electrodes 43, 44 are physically separated from each other and cover parts of the right side face of the piezoelectric crystal portion 4p.

The right electrode 43 on the upper side extends from near the border between the fixed portion 1C and the vibrating bar R3 toward the tip of the vibrating bar R3 along the longitudinal direction of the upper electrode 41 as maintaining a constant clearance to the upper electrode 41 and it is physically separated from the upper electrode 41. The left electrodes 45, 46 cover parts of the left side face of the piezoelectric crystal portion 4p.

The left electrode 45 on the upper side also extends from near the border between the fixed portion 1C and the vibrating bar R3 toward the tip of the vibrating bar R3 along the longitudinal direction of the upper electrode 41 as maintaining a constant clearance to the upper electrode 41 and it is physically separated from the upper electrode 41. Each of the electrodes 44, 46 on the left and right side faces and on the lower side also maintains a constant clearance to the lower electrode 42 so as to be physically separated therefrom.

The vibrating bar L3 is composed of piezoelectric crystal portion 5p made of the piezoelectric crystal and, upper electrode 51, lower electrode 52, right electrodes 53, 54 and left electrodes 55, 56 fixed to the respective side faces of the piezoelectric crystal portion 5p. Since the vibrating bar L3 has the same structure as the vibrating bar R3, description of the details of the structure is omitted herein.

The terminals T3 and T4 are connected to the inverting input terminals of the charge amplifiers 10x and 11x shown in Fig. 5 and the potentials thereof are fixed at 2.5 V by imaginal short. Thus, when the potential varying periodically is given to the electrodes 51, 52 through the terminal T2, a potential difference is given between the electrode group 51, 52 and the electrode group 53 to 56, whereby the piezoelectric crystal portion 5p vibrates along the X-axis directions, based on the inverse piezoelectric effect. Since the piezoelectric crystal portion 4p is mechanically coupled with the piezoelectric crystal portion 5p through the fixed portion 1C, the piezoelectric crystal portion 4p vibrates in the X-axis directions with the vibration of the piezoelectric crystal portion 5p. When the piezoelectric crystal portion 4p vibrates in the X-axis directions, the charge occurs in the central region of the side faces of the piezoelectric crystal portion 4p. This charge is subjected to the current-voltage conversion through the terminal T1, and the vibrating bars R3 and L3 thus continue vibrating.

When at this time the rotation about the center axis parallel to the Y-axis is applied onto the vibrator 102C, the Coriolis' force acts on the vibrating bars R3 and L3, and the vibrating bars R3 and L3 vibrate along the Z-axis directions, so that the piezoelectric crystal portions 4p, 5p are distorted along the Z-axis directions. The electrodes 43 to 46, 53 to 56 have the same functions as the electrodes 6a to 6d, 7a to 7d, respectively, of Fig. 5. Accordingly, the processing circuit 103 detects the amount of this distortion through the electrodes 43 to 46, 53 to 56 for detection, whereby it can detect the Coriolis' force acting on the vibrator 102C.

Another apparatus may employ the following arrangement of the electrodes for excitation and the electrodes for detection.

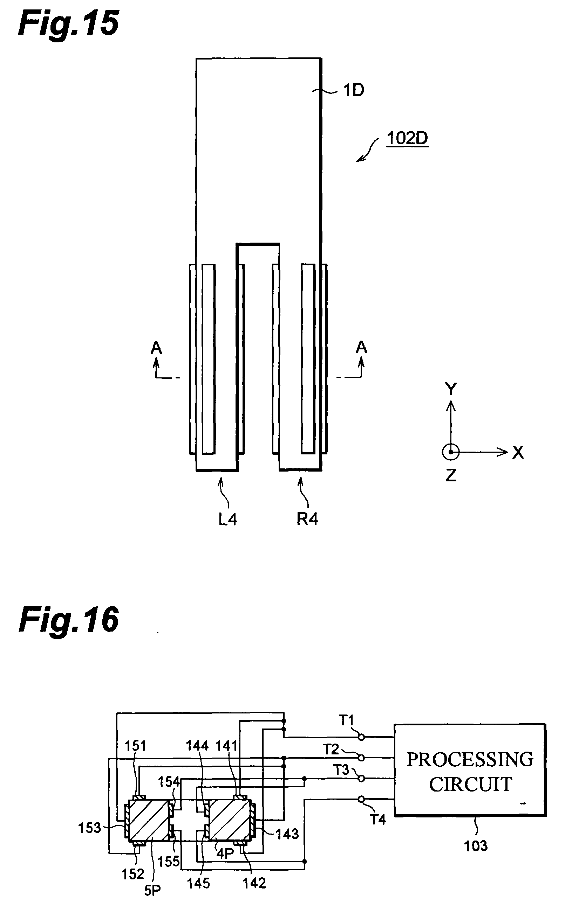

Fig. 15 is a plan view of such vibrator 102D and Fig. 16 shows a cross section of the vibrator 102D obtained by cutting the vibrator 102D along line A-A of Fig. 15 and observing it along the arrows and the processing circuit 103 connected thereto. The angular velocity detecting apparatus using this vibrator 102D will be described and redundant description will be omitted, because the same elements are denoted by the same reference symbols.

The vibrator 102D has a fixed portion 1D and a pair of vibrating bars L4 and R4 spaced a predetermined distance apart from each other and extending in parallel from the fixed portion 1D. The present angular velocity detecting apparatus is the resultant of replacement of the vibrator 102 shown in Fig. 1 with the vibrator 102D and the fixed portion 1D of the vibrator 102D is fixed to the setting surface S2 of the setting stage 101 of Fig. 1.

The vibrating bar R4 is composed of piezoelectric crystal portion 4p made of the piezoelectric crystal and, upper electrode 141, lower electrode 142, right electrode 143 and left electrodes 144, 145 fixed to the respective side faces of the piezoelectric crystal portion 4p.

The upper electrode 141 is formed only on the upper face of the piezoelectric crystal portion 4p and extends from near the border between the fixed portion 1D and the vibrating bar R4 toward the tip of the vibrating bar R4. The lower electrode 142 is formed only on the lower face of the piezoelectric crystal portion 4p and extends from near the border between the fixed portion 1D and the vibrating bar R4 toward the tip of the vibrating bar R4. The right electrode 143 covers a part of the right side face of the piezoelectric crystal portion 4p.

The right electrode 143 extends from near the border between the fixed portion 1D and the vibrating bar R4 toward the tip of the vibrating bar R4 along the longitudinal direction of the upper electrode 141 as maintaining a constant clearance to the upper electrode 141 and it is physically separated from the upper electrode 141. The left electrodes 144, 145 are physically separated from each other and cover parts of the left side face of the piezoelectric crystal portion 4p.

The left electrode 144 on the upper side also extends from near the border between the fixed portion 1D and the vibrating bar R4 toward the tip of the vibrating bar R4 along the longitudinal direction of the upper electrode 141 as maintaining a constant clearance to the upper electrode 141 and it is physically separated from the upper electrode 141. Further, the electrode 145 on the left side face and on the lower side also maintains a constant clearance to the lower electrode 142 and is physically separated therefrom. The shortest distance between the upper electrode 141 and the right electrode 143 is shorter than the shortest distance between the upper electrode 141 and the upper-side left electrode 144. The shortest distance between the lower electrode 142 and the right electrode 143 is also shorter than the shortest distance between the lower electrode 142 and the lower-side left electrode 145.

The vibrating bar L4 is composed of piezoelectric crystal portion 5p made of the piezoelectric crystal and, upper electrode 151, lower electrode 152, left electrode 153 and right electrodes 154, 155 fixed to the respective side faces of the piezoelectric crystal portion 5p. The vibrating bars R4 and L4 are in the mirror image relation with respect to the YZ plane located at the middle position between these vibrating bars R4 and L4. Therefore, since the vibrating bar L4 has the same structure as the vibrating bar R4, description of the details of the structure is omitted herein.

In the present apparatus, when the potential varying periodically is given to the electrodes 141, 142, 153 for excitation through the terminal T1, because the potential of the terminals T2 to T4 is fixed at 2.5 V, a potential difference is given between the electrode group 141, 142, 153 and the electrode group 143 to 145, 151, 152 to 155, whereby the vibrating bars R4 and L4 vibrate along the X-axis directions, based on the inverse piezoelectric effect. This vibration is detected through the electrodes 143, 151, 152 connected to the terminal T2 and this vibration continues.

When at this time the rotation about the center axis parallel to the Y-axis is applied onto the vibrator 102D, the Coriolis' force acts on the vibrating bars R4 and L4, and the vibrating bars R4 and L4 vibrate along the Z-axis directions, so that the piezoelectric crystal portions 4p, 5p are distorted along the Z-axis directions. The charge occurring with this distortion in the Z-axis directions is introduced through the electrodes 141, 145, 154, 155 for detection into the processing circuit 103. Accordingly, the processing circuit 103 detects the amount of this distortion through the electrodes 144, 145, 154, 155 for detection, whereby it can detect the Coriolis' force acting on the vibrator 102D.

Another apparatus may employ the following arrangement of the electrodes for excitation and the electrodes for detection.

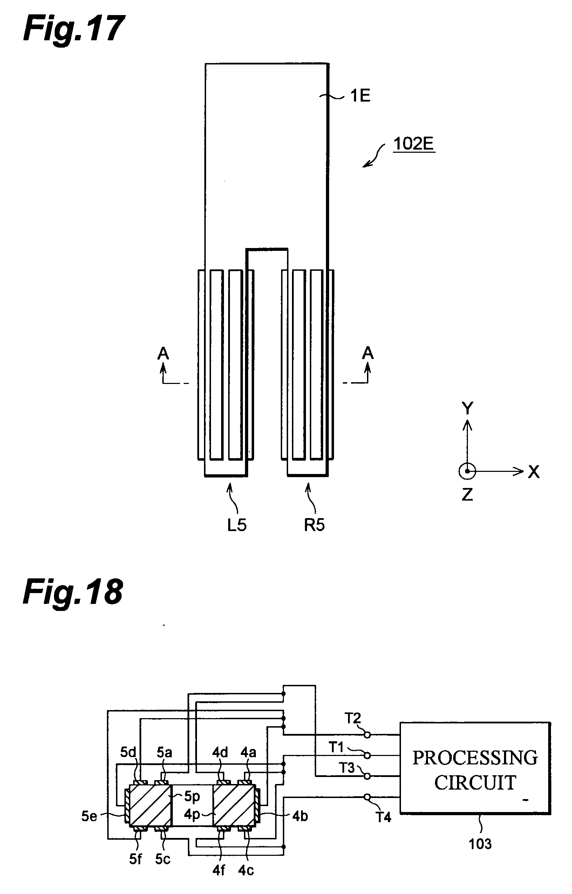

Fig. 17 is a plan view of such vibrator 102E and Fig. 18 shows a cross section of the vibrator 102E obtained by cutting the vibrator 102E along line A-A of Fig. 17 and observing it along the arrows and the processing circuit 103 connected thereto. The angular velocity detecting apparatus using this vibrator 102E will be described and redundant description will be omitted, because the same elements are denoted by the same reference symbols.

The vibrator 102E has a fixed portion 1E and a pair of vibrating bars L5 and R5 spaced a predetermined distance apart from each other and extending in parallel from the fixed portion 1E. The present angular velocity detecting apparatus is the resultant of replacement of the vibrator 102 shown in Fig. 1 with the vibrator 102E and the fixed portion 1E of the vibrator 102E is fixed to the setting surface S2 of the setting stage 101 of Fig. 1. The vibrator 102E is one obtained by removing the electrodes 4e and 5b from the vibrator 102B, the other structure is the same as 102B, and the description is thus omitted.

The material for the piezoelectric crystal portions according to the above embodiments was quartz, but it may be another piezoelectric crystal such as $LiTaO_3$. Further, the vibrating bars may be made by using PZT (lead titanate zirconate) or the like as the piezoelectric crystal material, placing this piezoelectric crystal between electrodes, and bonding it to metal or the like.

In the angular velocity detecting apparatus using the vibrator 102, the potential difference based on the piezoelectric effect occurs between the electrodes 4a to 4f, 5a to 5f provided on the piezoelectric crystal portions 4p and 5p with vibration of the piezoelectric crystal portions 4p and 5p. In the case of the angular velocity detecting apparatus according to this embodiment, the electric current flowing based on this potential difference is converted to the voltage, the converted voltage is amplified by the differential amplifier 12x, and the amplified voltage is output as an alternating voltage; but this potential difference may be subjected to waveform shaping, amplification, or phase conversion, or the like and the alternating voltage may be the potential difference itself.

When the second piezoelectric crystal portion 6p vibrates, the potential difference occurs at least between the electrode 6a and electrode 6c provided on the second piezoelectric crystal portion 6p, based on the piezoelectric effect. This potential difference is subjected to waveform shaping, amplification, or phase conversion, or the like to be converted to the alternating voltage signal $V_K$ having the signal component corresponding to this potential difference. The alternating voltage signal $V_K$ may be the above potential difference itself. A voltage obtained by converting the electric current flowing based on this potential difference thereto is also defined as the signal component corresponding to the potential difference.

Further, the signal from the terminal T1 was supplied to the operational amplifier A2 of the current-voltage converting circuit 2x according to each embodiment through the inverting input terminal 21 thereof, but it may be supplied to the non-inverting input terminal 22.

As described above, the angular velocity detecting apparatus according to the above embodiments comprise the vibrator 102 having the first piezoelectric crystal portion 4p made of the piezoelectric crystal, the first and second electrodes 4m, 4u provided on the first piezoelectric crystal portion 4p, and the vibrating bar for detection 6 mechanically coupled with the first piezoelectric crystal portion 4p; and the circuit 103 having the excitation means 103a for giving the potential $V_A$ varying at the predetermined period to the first electrode 4m, the potential fixing means 2x for fixing the potential of the second electrode 4u at the predetermined value, and the detecting means 103b for detecting the amount of strain occurring in the vibrating bar for detection 6.

Since the amount of strain occurring in the vibrating bar for detection 6, i.e., the alternating voltage signal $V_K$ is generated by transmission of the vibration or the like based on the Coriolis' force of the first piezoelectric crystal portion 4p to the vibrating bar for detection 6, it contains the voltage component due to the Coriolis' force. The detecting means 103b detects this alternating voltage signal $V_K$, i.e., the amount of strain occurring in the vibrating bar for detection 6, whereby the magnitude of the Coriolis' force can be detected. Thus, the magnitude of the angular velocity of the detected body can be detected.

According to the present apparatus, since the potential of the second electrode 4u is fixed at the predetermined value by the potential fixing means 2x, the vibration of the first piezoelectric crystal portion 4p is stable. Once the vibration of the first piezoelectric crystal portion 4p becomes stable, the vibration based on the foregoing vibration and the Coriolis' force becomes stable. Therefore, the vibration of the vibrating bar for detection 6 mechanically coupled with the first piezoelectric crystal portion 4p becomes stable, whereby the accuracy of the angular velocity detected by the detecting means 103b can be enhanced.

In a preferred arrangement, the potential fixing means 2x of the present apparatus has the operational amplifier A2 having the inverting input terminal 21, the non-inverting input terminal 22, and the output terminal B, and the resistor R2 connected between the output terminal B and the inverting input terminal 21 of the operational amplifier A2 and having the predetermined resistance; the second electrode 4u is electrically connected to one 21 of the input terminals of the operational amplifier A2; and the potential of the other 22 of the input terminals of the operational amplifier A2 is fixed at the predetermined value.

In the present apparatus, the inverting input terminal 21 and the non-inverting input terminal 22 are in the imaginal short state, so that the potential of the inverting input terminal 21 is equal to the potential of the non-inverting input terminal 22. By the voltage drop due to the resistor R2, the electric current signal corresponding to the potential difference between the first electrode 4m and the second electrode 4u is converted to the voltage signal $V_B$.

In a further preferred arrangement, the vibrating bar for detection 6 has the second piezoelectric crystal portion 6p made of the piezoelectric crystal, and the plurality of other electrodes 6a, 6c than the first and second electrodes 4m, 4u, provided on the second piezoelectric crystal portion 6p; the excitation means 103a is electrically connected to the operational amplifier A2 so that the excitation means 103a generates the potential $V_A$ varying at the predetermined period from the output signal $V_B$ of the operational amplifier A2; the detecting means 103b is means for detecting the alternating voltage signal $V_K$ having the signal component corresponding to the potential difference generated between the other electrodes 6a, 6c; and the detecting means 103b is electrically connected to the excitation means 103a so that the detecting means 103b synchronously detects the alternating voltage signal $V_K$ with the signals $V_M$, $V_N$ synchronized with the output signal $V_B$ of the operational amplifier A2.

In this case, the operational amplifier A2 outputs the signal $V_B$ synchronized with the vibration of the first piezoelectric crystal portion 4p while fixing the potential of the second electrode 4u at the predetermined value, and the excitation means 103 applies the potential $V_A$ for vibrating the first piezoelectric crystal portion 4p to the first electrode 4m, utilizing the output signal $V_B$ of the operational amplifier A2. The detecting means 103b synchronously detects the alternating voltage signal $V_K$ with the signals $V_M$, $V_N$ synchronized with the output signal $V_B$ of the operational amplifier A2. Therefore, the present configuration can achieve these functions using the output $V_B$ based on one operational amplifier A2.

In a further preferred arrangement, the present apparatus comprises the first charge amplifier 10x connected to one 6a of the other electrodes, the second charge amplifier 11x connected to the other 6c of the other electrodes, and the differential amplifier 12x connected to the output terminals of the first and second charge amplifiers 10x, 11x; the alternating voltage signal $V_K$ is output from the differential amplifier 12x; and the first and second charge amplifiers 10x, 11x are set so that the phase of the alternating voltage signal $V_K$ output from the differential amplifier 12x is coincident with or different 180° from the phase of the alternating voltage signal $V_B$ output from the potential fixing means 2x.

There is the phase difference of 90° between the vibrating velocity of the first piezoelectric crystal portion 4p and the Coriolis' force acting on the first piezoelectric crystal portion 4p. Since the second piezoelectric crystal portion 6p vibrates based on this Coriolis' force, there is the phase difference of 90° between the vibrating velocities of the first and second piezoelectric crystal portions. Accordingly, for synchronous detection of the signal $V_K$ from the second piezoelectric crystal portion 6p with the signal $V_B$ from the first piezoelectric crystal portion 4p, a phase shifter for converting either one phase by 90° is necessary. However, since in the present apparatus the phase of the signal $V_K$ output from the differential amplifier 12x is coincident with or different 180° from the phase of the alternating voltage signal $V_B$, the synchronous detection can be made without using the phase shifter of 90°.

Further, the first and second piezoelectric crystal portions 4p, 6p shown in Figs. 1 to 3 may be the common portion 4p, for example as shown in Fig. 12. In this case, because the first electrode 4b, second electrode 4a, and the other electrodes 4d, 4f are formed on the same portion, the configuration of apparatus is simplified.

In the angular velocity detecting apparatus according to the present invention, as described above, since the potential of the second electrode is fixed at the predetermined value by the potential fixing means, the vibration of the first piezoelectric crystal portion is stable, so that the accuracy of the angular velocity detected by the detecting means can be enhanced.

From the invention thus described, it will be obvious that the invention may be varied in many ways. Such variations are not to be regarded as a departure from the spirit and scope of the invention, and all such modifications as would be obvious to one skilled in the art are intended for inclusion within the scope of the following claims.

The basic Japanese Application No.8-212614 (212614/1996) filed on August 12, 1996 is hereby incorporated by reference.

The angular velocity detecting apparatus comprises a vibrator 102 having first and second piezoelectric crystal portions 4p, 6p made of a piezoelectric crystal and a circuit 103. This circuit 103 gives an electrode 4m a potential $V_A$ varying at a predetermined period, and fixes the potential of an electrode 4u at a predetermined value, and detects an alternating voltage signal $V_K$ having a signal component corresponding to a potential difference occurring between the other electrodes 6a, 6b.

**Claims**

1. An angular velocity detecting apparatus, comprising:

   a vibrator (102) having: a first piezoelectric crystal portion (4p) made of a piezoelectric crystal, first and second electrodes (4m, 4u) provided on said first piezoelectric crystal portion (4p), and a vibrating bar for detection (6) mechanically coupled with said first piezoelectric crystal portion (4p); and

   a circuit (103) having a excitation means (103a) for giving a potential ($V_A$) varying at a predetermined period to said first electrode (4m), a potential fixing means (2x) for fixing the potential of said second electrode (4u) at a predetermined value, and a detecting means (103b) for detecting the amount of strain occurring in said vibrating bar for detection (6).

2. An apparatus according to Claim 1,

   wherein said potential fixing means (2x) has an operational amplifier (A2) having an inverting input terminal (21), a non-inverting input terminal (22), and an output terminal (B), and a resistor (R2) connected between the output terminal (B) and the inverting input terminal (21) of said operational amplifier (A2) and having a predetermined resistance;
   wherein said second electrode (4u) is electrically connected to one (21) of the input terminals of said operational amplifier (A2); and
   wherein the potential of the other (22) of the input terminals of said operational amplifier (A2) is fixed at a predetermined value.

3. An apparatus according to Claim 2,

   wherein said vibrating bar for detection (6) has a second piezoelectric crystal portion (6p) made of the piezoelectric crystal, and a plurality of other electrodes (6a, 6c) than the first and second electrodes (4m, 4u), said other electrodes (6a, 6c) being provided on said second piezoelectric crystal portion (6p);
   wherein said excitation means (103a) is electrically connected to said operational amplifier (A2) so that said excitation means (103a) generates the potential ($V_A$) varying at the predetermined period from an output signal ($V_B$) of said operational amplifier (A2);
   wherein said detecting means (103b) is means for detecting an alternating voltage signal ($V_K$) having a signal component corresponding to the potential difference generated between the other electrodes (6a, 6c); and
   wherein said detecting means (103b) is electrically connected to said excitation means (103a) so that said detecting means (103b) synchronously detects the alternating voltage signal ($V_K$) with signals ($V_M$, $V_N$) synchronized with the output signal ($V_B$) of the operational amplifier (A2).

4. An apparatus according to claim 1, further comprising:

   a first charge amplifier (10x) connected to one

(6a) of the other electrodes;

a second charge amplifier (11x) connected to the other (6c) of the other electrodes; and

a differential amplifier (12x) connected to output terminals of the first and second charge amplifiers (10x, 11x), wherein the alternating voltage signal ($V_K$) is output from said differential amplifier (12x); and wherein said first and second charge amplifiers (10x, 11x) are set so that the phase of the alternating voltage signal ($V_K$) output from said differential amplifier (12x) is coincident with or different 180° from the phase of said alternating voltage signal ($V_B$) output from said potential fixing means (2x).

# Fig.1

*Fig.2*

*Fig.3*

*Fig.4*

Fig.5

EP 0 825 417 A2

Fig.6A

Fig.6B

Fig.6C

Fig.6D

Fig.6E

Fig.6F

Fig.6G

Fig.6H

Fig.6I

Fig.6J

Fig.6K

Fig.6L

Fig.6M

Fig.6N

Fig.6O

Fig.6P

Fig.6Q

Fig.6R

# Fig.7

EP 0 825 417 A2

*Fig.8*

**Fig.9**

**Fig.10**

PROCESSING CIRCUIT

**Fig.11**

**Fig.12**

PROCESSING CIRCUIT

103

## Fig.13

1C

102C

51    41

45

A    A

55    53    43

L3    R3

## Fig.14

T1

T4    PROCESSING
CIRCUIT

51    53  45    41    T3

43

5P  55

56    4P

T2

52    54  46    44

42    103

**Fig.15**

**Fig.16**

PROCESSING CIRCUIT

## Fig.17

## Fig.18